# EUROPEAN PATENT APPLICATION

(11) **EP 4 779 735 A1**
(43) Date of publication of application: **22.07.2026**
(21) Application number: 25216182.3
(22) Date of filing: 17.11.2025
(51) Int. Cl.: H01M 10/0525, G01R 31/3842, G01R 31/392, H01M 10/42, H01M 10/44, H01M 4/58

(54) **BATTERY SYSTEM**

(30) Priority: 16.12.2024 JP 2024220146
(71) Applicant: Toyota Jidosha Kabushiki Kaisha, Toyota-shi, Aichi-ken 471-8571 (JP)
(72) Inventor: ITO, Hirotaka, Toyota-shi, Aichi-ken 471-8571 (JP); MANO, Ryo, Toyota-shi, Aichi-ken 471-8571 (JP); ISHII, Kenta, Toyota-shi, Aichi-ken 471-8571 (JP)
(74) Representative: J A Kemp LLP

(57) **Abstract**

A battery system includes a battery made of a lithium-ion secondary battery, a sensor group configured to detect a voltage, a current, and a temperature of the battery, and a control device configured to control a charging current of the battery based on detection values of the sensor group. The control device is configured to acquire a deterioration state of the battery from the detection values of the sensor group, and set a threshold voltage at which lithium metal is deposited on an electrode of the lithium-ion secondary battery with respect to the voltage of the battery, in accordance with the acquired deterioration state of the battery. The control device is configured to reduce, when the voltage of the battery exceeds the threshold voltage during charging of the battery, the charging current to a limit current.

## Description

### BACKGROUND OF THE INVENTION

### 1. Field of the Invention

The present disclosure relates to a battery system.

### 2. Description of Related Art

Japanese Unexamined Patent Application Publication No. 2014-163861 (JP 2014-163861 A) discloses, based on an SOC-CCV characteristic that represents a correlation between a state of charge (SOC) and a closed circuit voltage (CCV) of a lithium-ion secondary battery, a technique for estimating the SOC of the lithium-ion secondary battery.

### SUMMARY OF THE INVENTION

The higher a deterioration degree of a lithium-ion secondary battery is, the higher internal resistance is. As the internal resistance increases, a potential difference between an open circuit voltage (OCV) and a CCV of the lithium-ion secondary battery increases. Therefore, depending on a deterioration state of the lithium-ion secondary battery, lithium metal may be deposited on a negative electrode surface of the lithium-ion secondary battery before the SOC becomes an SOC value indicating a fully charged state during charging of the lithium-ion secondary battery.

The present disclosure has been made to solve the problems, and provides a battery system capable of suppressing deposition of the lithium metal during charging of the lithium-ion secondary battery even when the lithium-ion secondary battery deteriorates.

A battery system according to an aspect of the present disclosure includes a lithium-ion secondary battery, a sensor group configured to detect a voltage, a current, and a temperature of the lithium-ion secondary battery, and a control device configured to control a charging current of the lithium-ion secondary battery based on detection values of the sensor group. The control device is configured to acquire a deterioration state of the lithium-ion secondary battery from the detection values of the sensor group. The control device is configured to set a threshold voltage at which lithium metal is deposited on an electrode of the lithium-ion secondary battery with respect to the voltage of the lithium-ion secondary battery, in accordance with the acquired deterioration state of the lithium-ion secondary battery. The control device is configured to reduce, when the voltage of the lithium-ion secondary battery exceeds the threshold voltage during charging of the lithium-ion secondary battery, the charging current of the lithium-ion secondary battery to a limit current.

According to the present disclosure, it is possible to provide a battery system capable of suppressing deposition of the lithium metal during charging of the lithium-ion secondary battery even when the lithium-ion secondary battery deteriorates.

### BRIEF DESCRIPTION OF THE DRAWINGS

Features, advantages, and technical and industrial significance of exemplary embodiments of the invention will be described below with reference to the accompanying drawings, in which like signs denote like elements, and wherein:
FIG. 1 is a diagram showing an example of an overall configuration of an electrified vehicle to which a battery system according to a present embodiment is applied;
FIG. 2 is a diagram showing a configuration of a battery and a monitoring unit in more detail;
FIG. 3 is a graph showing an example of an SOC-OCP curve and an SOC-CCP curve of an LFP battery;
FIG. 4 is a graph showing an example of a temporal change in a resistance of a positive electrode and a resistance of a negative electrode of the LFP battery;
FIG. 5 is a flowchart showing a processing procedure of charging control of the battery in the present embodiment; and
FIG. 6 is a graph for describing an example of the charging control of the battery according to the present embodiment.

### DETAILED DESCRIPTION OF EMBODIMENTS

In the following, an embodiment of the present disclosure will be described in detail with reference to the drawings. It should be noted that, in the drawings, the same or corresponding parts are designated by the same reference signs and the description thereof will not be repeated.

### Overall Configuration of Electrified Vehicle

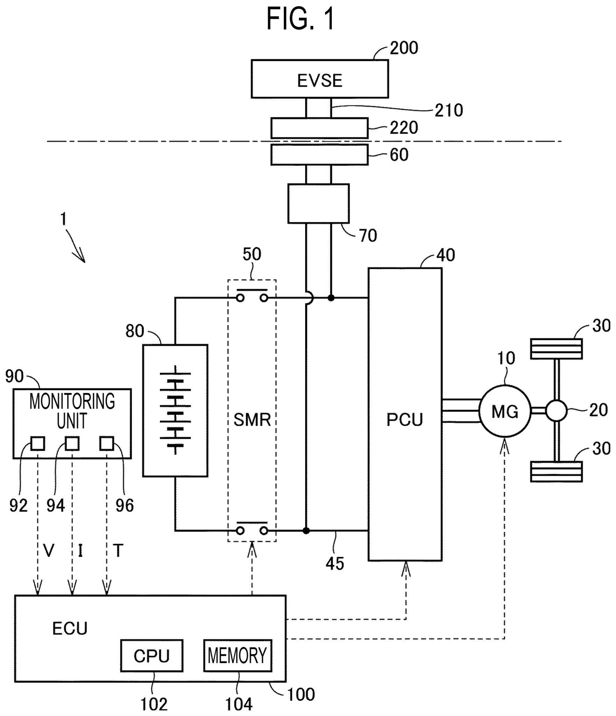

FIG. 1 is a diagram showing an example of an overall configuration of an electrified vehicle to which a battery system according to a present embodiment is applied. An electrified vehicle 1 according to the present embodiment is, for example, a battery electric vehicle. The electrified vehicle 1 may be a hybrid electric vehicle, a plug-in hybrid electric vehicle, or the like.

The electrified vehicle 1 includes a motor generator (MG) 10, a power transmission gear 20, drive wheels 30, a power control unit (PCU) 40, a system main relay (SMR) 50, a battery 80, a monitoring unit 90, and an electronic control unit (ECU) 100.

The MG 10 is an alternating current rotary electric machine, and is, for example, a three-phase alternating current synchronous electric motor in which a permanent magnet is embedded in a rotor. The MG 10 is driven by receiving supply of power from the battery 80 via the PCU 40. A driving force of the MG 10 is transmitted to the drive wheels 30 via the power transmission gear 20 configured to include a speed reducer, a differential device, and the like.

During braking of the electrified vehicle 1 or during reduction of acceleration on a downhill slope, the MG 10 is driven by the drive wheels 30, and the MG 10 operates as a generator to perform regenerative power generation. The power generated by the MG 10 is stored in the battery 80 via the PCU 40.

The PCU 40 is a power conversion device that converts power between the MG 10 and the battery 80 in both directions. The PCU 40 includes, for example, an inverter and a converter that operate based on a control signal from the ECU 100.

The converter boosts a direct current voltage supplied from the battery 80 and supplies the boosted direct current voltage to the inverter during discharging of the battery 80. The inverter converts direct current power supplied from the converter into alternating current power to drive the MG 10.

The inverter converts the alternating current power generated by the MG 10 into the direct current power and supplies the direct current power to the converter during charging of the battery 80. The converter steps down the direct current voltage supplied from the inverter to a voltage suitable for charging of the battery 80, and supplies the direct current voltage to the battery 80.

The SMR 50 is electrically connected to a power line 45 connecting the battery 80 and the PCU 40. When the SMR 50 is closed (turned ON) in response to the control signal from the ECU 100, power may be exchanged between the battery 80 and the PCU 40. On the other hand, when the SMR 50 is opened (turned OFF) in response to the control signal from the ECU 100, electrical connection between the battery 80 and the PCU 40 is disconnected.

The battery 80 stores power for driving the MG 10. The battery 80 is a rechargeable direct current power source (secondary battery), and is a battery pack configured by electrically connecting a plurality of single batteries (cells) in series. Each cell is a lithium-ion secondary battery. In the present embodiment, a lithium iron phosphate battery (LFP battery) using lithium iron phosphate as a positive electrode active material is adopted as a cell.

The monitoring unit 90 is a device for monitoring a state of the battery 80, and includes a voltage sensor group 92, a current sensor 94, and a temperature sensor group 96. The voltage sensor group 92 includes a plurality of voltage sensors. Each of the voltage sensors detects a voltage V of a corresponding cell among the cells included in the battery 80. The current sensor 94 detects a current I input to and output from the battery 80. The temperature sensor group 96 includes one or more temperature sensors. Each of the one or more temperature sensors detects a temperature T of a corresponding cell among the cells included in the battery 80. The monitoring unit 90 outputs a detection value by each sensor to the ECU 100.

The electrified vehicle 1 includes an inlet 60, and is configured to perform external charging of the battery 80 using electric vehicle supply equipment (EVSE) 200. The inlet 60 is configured to be connected to a connector 220 provided at a distal end of a charging cable 210 of the EVSE 200. The inlet 60 is electrically connected to the power line 45 via a charging circuit 70. In the present embodiment, when the SMR 50 is closed, the inlet 60 and the battery 80 are electrically connected, and the external charging is enabled.

The ECU 100 includes a central processing unit (CPU) 102, a memory 104 such as a read only memory (ROM) and a random access memory (RAM), and an input and output port (not shown) for inputting and outputting various signals. The ECU 100 executes control related to traveling of the vehicle and charging and discharging of the battery 80 based on signals received from each sensor of the monitoring unit 90, and the program and the map stored in the memory 104.

In addition, the ECU 100 reduces a charging current of the battery 80 as a measure for protecting the battery 80 from deposition of lithium metal (hereinafter, also referred to as "Li deposition") on a negative electrode surface of each cell during charging of the battery 80.

The ECU 100 corresponds to an embodiment of a "control device". The ECU 100 may be divided into a plurality of ECUs for each function. It should be noted that, at least a part of the ECU 100 can be constructed by dedicated hardware (electronic circuit) and can be processed.

### Configuration of Battery and Monitoring Unit

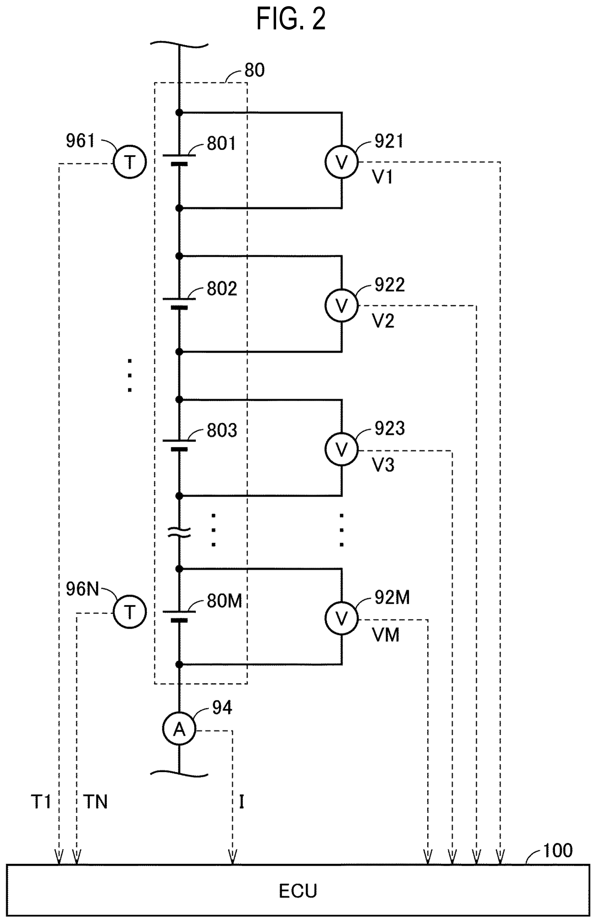

FIG. 2 is a diagram showing a configuration of the battery 80 and the monitoring unit 90 in more detail. As shown in FIG. 2, the battery 80 includes M cells 801 to 80M connected in series. M may be an integer of 2 or more, and is typically from a dozen to several dozen.

The voltage sensor group 92 is implemented by, for example, a voltage monitoring integrated circuit (IC) in which a processing circuit of a large number of voltage sensors is integrated, and is integrally configured. The voltage sensor group 92 includes M voltage sensors 921 to 92M. The voltage sensor 921 detects a voltage V1 of the cell 801. The voltage sensor 922 detects a voltage V2 of the cell 802. The same applies to the voltage sensors 923 to 92M other than the voltage sensors 921, 922.

The current sensor 94 detects the current I flowing through the battery 80 (that is, the current I flowing through the cells 801 to 80M in common).

The temperature sensor group 96 includes N temperature sensors 961 to 96N. N is an integer of 1 or more and less than M. That is, the temperature sensor is not provided in all the cells. In the example of FIG. 2, the temperature sensor 961 detects a temperature T1 of the cell 801. The temperature sensor 96N detects a temperature TN of a cell 80N. It should be noted that, a cell to which the temperature sensor is to be installed is not limited to a cell at both ends as in the example, and may be appropriately set.

It should be noted that, in FIG. 2, the configuration in which all the cells included in the battery 80 are connected in series is shown as an example, but the configuration of the battery 80 is not limited thereto. The battery 80 may include two or more cell groups with all the cells in each group connected in series.

### Protective Measure for Li Deposition

The lithium-ion secondary battery discharges and charges through a chemical reaction (battery reaction) at an interface between each of a negative electrode active material and a positive electrode active material and an electrolyte. During charging of the battery, a battery reaction of releasing lithium ions and electrons is performed on an interface of the positive electrode active material, and a battery reaction of absorbing the lithium ions and the electrons is performed on an interface of the negative electrode active material. During discharging of the battery, a battery reaction in which release and absorption are reversed is performed. During charging of the lithium-ion secondary battery, absorption diffusion in a negative electrode may not keep up with supply of the lithium ions, and the lithium metal may be deposited on the negative electrode surface.

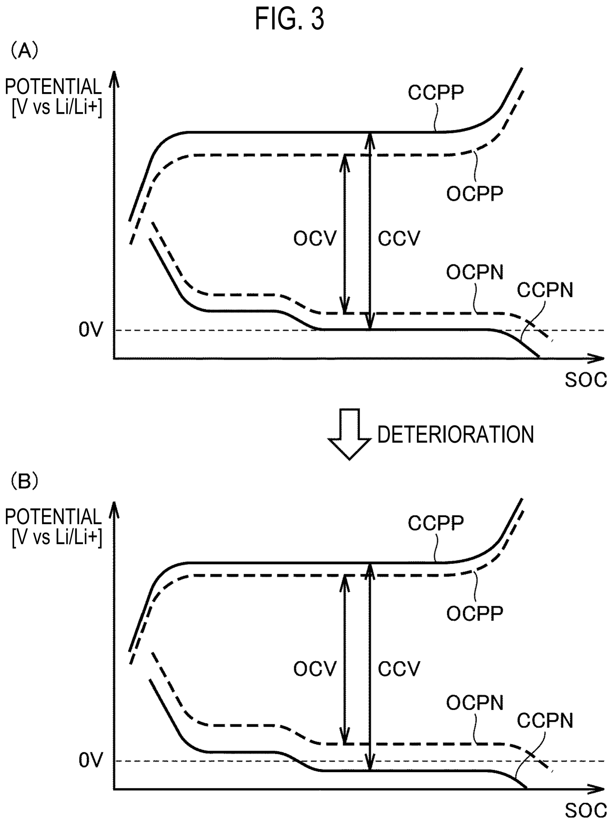

Hereinafter, a change in a potential of the negative electrode when the Li deposition occurs in the LFP battery will be described. FIG. 3 is a graph showing an example of an SOC-OCP curve and an SOC-CCP curve of the LFP battery. A part (A) of FIG. 3 shows the SOC-OCP curve and the SOC-CCP curve in an initial state (for example, at the time of new purchase) of the LFP battery. A part (B) of FIG. 3 shows the SOC-OCP curve and the SOC-CCP curve in a state where the LFP battery deteriorates.

In each of the graphs of the part (A) of FIG. 3 and the part (B) of FIG. 3, a horizontal axis is an SOC of the LFP battery, and a vertical axis is a potential of the positive electrode and the negative electrode of the LFP battery. A broken line represents a relationship between an OCPP which is an open circuit potential (OCP) of the positive electrode of the LFP battery and the SOC (hereinafter, referred to as an "SOC-OCPP curve"), and a relationship between an OCPN which is an OCP of the negative electrode and the SOC (hereinafter, also referred to as an "SOC-OCPN curve"). A solid line represents a relationship between a CCPP which is a closed circuit potential (CCP) of the positive electrode of the LFP battery and the SOC (hereinafter, also referred to as an "SOC-CCPP curve"), and a relationship between a CCPN which is a CCP of the negative electrode and the SOC (hereinafter, also referred to as an "SOC-CCPN curve").

In addition, in each of the graphs, an open circuit voltage (OCV) of the LFP battery corresponds to a difference between the open circuit potential of the positive electrode OCPP and the open circuit potential of the negative electrode OCPN. A closed circuit voltage (CCV) of the LFP battery corresponds to a difference between the closed circuit potential of the positive electrode CCPP and the closed circuit potential of the negative electrode CCPN.

As shown in the part (A) of FIG. 3, the SOC-OCPP curve has a very high flatness except a low SOC region and a high SOC state close to a fully charged state. Therefore, an SOC-OCV curve of the LFP battery can be said to be determined by a shape of the SOC-OCPN curve.

The SOC-OCPN curve also has the same flatness as the SOC-OCPP curve except the low SOC region. It should be noted that, in the SOC-OCPN curve, a "step" in which the open circuit potential of the negative electrode OCPN sharply decreases as the SOC increases is observed in a region where the SOC is moderate. Therefore, the OCV also sharply increases in the part with the increase in the SOC.

During charging of the LFP battery, the closed circuit potential of the positive electrode CCPP is higher than the open circuit potential of the positive electrode OCPP by an amount of a voltage generated across a resistance of the positive electrode. When the charging current of the LFP battery is defined as I and the resistance of the positive electrode of the LFP battery is defined as Rp, the closed circuit potential of the positive electrode CCPP is represented by CCPP = OCPP + I × Rp. The SOC-CCPP curve has a very high flatness except the high SOC state by reflecting the SOC-OCPP curve.

The closed circuit potential of the negative electrode CCPN is lower than the open circuit potential of the negative electrode OCPN by an amount of a voltage generated across a resistance of the negative electrode. When the charging current of the LFP battery is defined as I and the resistance of the negative electrode of the LFP battery is defined as Rn, the closed circuit potential of the negative electrode CCPN is represented by CCPN = OCPN - I × Rn. As a result, in the SOC-CCPN curve, a "step" in which the closed circuit potential of the negative electrode CCPN sharply decreases as the SOC increases is also observed in the region where the SOC is moderate.

Here, when the closed circuit potential of the negative electrode CCPN falls below a deposition potential of the lithium metal (hereinafter, also referred to as a "Li deposition potential") of 0 V during charging of the LFP battery, the lithium metal is deposited on a surface of the negative electrode of the LFP battery. When the lithium metal is excessively deposited, the deposited lithium metal may cause a short circuit between the positive electrode and the negative electrode of the LFP battery. Therefore, in the charging control of the LFP battery, it is desired to suppress the deposition of the lithium metal on the negative electrode surface.

As a protective measure for the Li deposition, a method can be adopted in which the CCV at which the Li deposition is started is set to a protection voltage for protecting the lithium-ion secondary battery from the Li deposition, and a charging current (charging power) of the lithium-ion secondary battery is reduced when the CCV of the lithium-ion secondary battery reaches the protection voltage. In the method, the protection voltage corresponds to a "threshold voltage" at which the lithium metal is deposited on the electrode of the lithium-ion secondary battery with respect to the voltage of the lithium-ion secondary battery.

For example, when the protection voltage is determined from the SOC-CCP curve shown in the part (A) of FIG. 3, and the charging current is controlled based on the protection voltage, it is possible to suppress a situation in which the closed circuit potential of the negative electrode CCPN falls below the Li deposition potential of 0 V, and suppress the Li deposition in the LFP battery.

However, as the LFP battery deteriorates as a result of repetition of charging and discharging, as shown in the part (B) of FIG. 3, the SOC-CCP curve of the LFP battery changes from the SOC-CCP curve in the initial state. It should be noted that the charging current of the LFP battery is the same in the part (A) of FIG. 3 and the part (B) of FIG. 3.

When the part (B) of FIG. 3 and the part (A) of FIG. 3 are compared, no significant difference is observed in the SOC-OCPP curve and the SOC-OCPN curve. On the other hand, a potential difference between the SOC-CCPP curve and the SOC-OCPP curve decreases due to the deterioration of the LFP battery as compared with that in the initial state. Since the potential difference corresponds to a product I × Rp of the charging current I and the resistance of the positive electrode Rp, it can be seen that the resistance of the positive electrode Rp decreases due to the deterioration of the LFP battery.

In contrast, a potential difference between the SOC-CCPN curve and the SOC-OCPN curve increases due to the deterioration of the LFP battery as compared with that in the initial state. Since the potential difference corresponds to a product I × Rn of the charging current I and the resistance of the negative electrode Rn, it can be seen that the resistance of the negative electrode Rn increases due to the deterioration of the LFP battery.

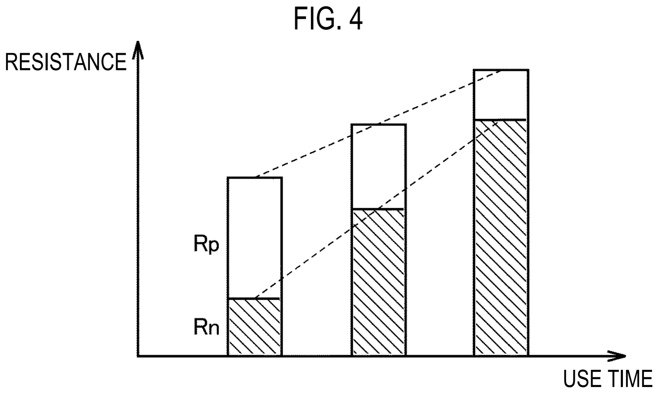

FIG. 4 is a graph showing an example of a temporal change in the resistance of the positive electrode Rp and the resistance of the negative electrode Rn of the LFP battery. FIG. 4 shows a manner in which the resistance of the positive electrode Rp and the resistance of the negative electrode Rn transition in accordance with a use time (the number of times of charging and discharging or the like) from the initial state of the LFP battery. A vertical axis of FIG. 4 indicates the resistance of the positive electrode Rp of the LFP battery, the resistance of the negative electrode Rn of the LFP battery, and a resistance of the entire LFP battery. The resistance of the entire LFP battery corresponds to Rp + Rn.

As shown in FIG. 4, in the initial state, the resistance of the positive electrode Rp is larger than the resistance of the negative electrode Rn. As the use time of the LFP battery increases, the resistance of the entire LFP battery increases. It should be noted that the resistance of the positive electrode Rp decreases as the use time of the LFP battery increases, and the resistance of the negative electrode Rn increases as the use time of the LFP battery increases. Therefore, in the example of FIG. 4, a size relationship between the resistance of the positive electrode Rp and the resistance of the negative electrode Rn is reversed. As the use time of the LFP battery increases as described above, a ratio of the resistance of the positive electrode Rp of the LFP battery to the resistance of the negative electrode Rn of the LFP battery changes.

In the part (B) of FIG. 3, the SOC-CCPN curve is shifted to a low potential side with respect to the SOC-CCPN curve in the initial state due to the increase in the resistance of the negative electrode Rn of the LFP battery. Therefore, the SOC when the closed circuit potential of the negative electrode CCPN reaches the Li deposition potential is lower than the SOC when the closed circuit potential of the negative electrode CCPN reaches the Li deposition potential in the initial state. As shown in FIG. 4, since the resistance of the negative electrode Rn increases as the deterioration of the LFP battery progresses, it is expected that the SOC at which the closed circuit potential of the negative electrode CCPN reaches the Li deposition potential further decreases as the deterioration of the LFP battery progresses. Therefore, when the charging current of the LFP battery is controlled based on the same protection voltage as that in the initial state, there is a concern that it may no longer be possible to suppress the Li deposition, depending on a deterioration state of the LFP battery.

In response to such a concern, in the present embodiment, the protection voltage is variably set in accordance with the deterioration state of the lithium-ion secondary battery. For example, in a case of the LFP battery, the SOC-OCP curve and the SOC-CCP curve shown in FIG. 3 are determined from an experiment or the like for each deterioration degree of the LFP battery, and the CCV when the closed circuit potential of the negative electrode CCPN reaches the Li deposition potential can be calculated as the protection voltage from the corresponding SOC-OCP curve and the SOC-CCP curve in accordance with the deterioration degree of the LFP battery. In some cases, the protection voltage is, in the SOC-CCP curve, set to the CCV or less when the closed circuit potential of the negative electrode CCPN of the LFP battery is the Li deposition potential.

It should be noted that, since the resistance of the negative electrode Rn increases as a temperature of the lithium-ion secondary battery decreases, the potential difference I × Rn between the SOC-CCPN curve and the SOC-OCPN curve also increases. Therefore, while the temperature is low, the closed circuit potential of the negative electrode CCPN is likely to fall below the Li deposition potential. Further, while the temperature is low, the absorption diffusion of the lithium ions in the negative electrode significantly slows down, so that the Li deposition is likely to occur.

Therefore, in the present embodiment, the protection voltage is variably set in accordance with the deterioration state and the temperature of the lithium-ion secondary battery. Specifically, a map or a formula that specifies a relationship between a deterioration degree and a protection voltage of the lithium-ion secondary battery for each temperature of the lithium-ion secondary battery is generated in advance by an experiment or the like and stored in the memory 104 of the ECU 100. The ECU 100 refers to the map or the formula to calculate the protection voltage from the temperature and the deterioration degree of the lithium-ion secondary battery.

### Processing Flow

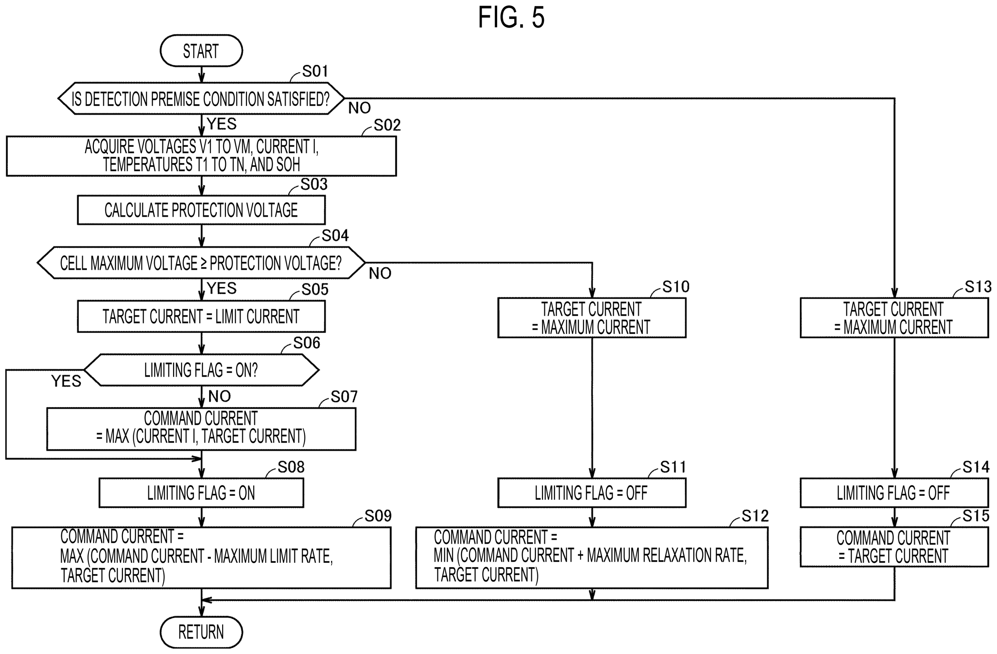

FIG. 5 is a flowchart showing a processing procedure of charging control of the lithium-ion secondary battery in the present embodiment. The flowchart is executed at the time when a condition that is predetermined by the ECU 100 is satisfied (for example, every time a control cycle is executed) during charging of the battery 80. Each step is realized by software processing by the ECU 100, but may be realized by hardware (electric circuit) disposed in the ECU 100. Hereinafter, the steps are abbreviated as S.

As shown in FIG. 5, first, the ECU 100 determines in S01 whether a detection premise condition is satisfied. The "detection premise condition" means that all the various sensors for detecting the state (voltage V, current I, and temperature T) of the battery 80, the ECU 100 main body, a power supply of the ECU 100, and the like are normal.

When the detection premise condition is satisfied (at the time when YES determination is made in S01), the ECU 100 executes processing for protecting the battery 80 from the Li deposition. Specifically, in S02, the ECU 100 acquires voltages V1 to VM from the voltage sensor group 92 (voltage sensors 921 to 92M), and acquires the current I from the current sensor 94. In addition, the ECU 100 acquires the temperatures T1 to TN from the temperature sensor group 96 (temperature sensors 961 to 96N).

In S02, the ECU 100 acquires a value indicating a deterioration degree of the cells 801 to 80M by using at least one of the voltages V1 to VM, the current I, and the temperatures T1 to TN. The value indicating the deterioration degree of each cell is, for example, a state of health (SOH).

Specifically, the ECU 100 calculates an estimated value of the SOH (hereinafter, referred to as "estimated SOH") [%] by using, for example, a fully charged estimated capacity Ces [Ah], a fully charged initial capacity Co [Ah], and a predetermined estimation formula. The estimation formula is represented by, for example, a formula of "estimated SOH = Ces/Co × 100".

Here, the fully charged initial capacity Co is a fully charged capacity when the battery deterioration does not occur. The fully charged initial capacity Co is, for example, a value that is predetermined by a type of the battery 80, and may be stored in the memory 104 of the ECU 100, may be acquired from a storage device of the monitoring unit 90, or may be acquired from an external server.

The fully charged estimated capacity Ces is, for example, an estimated value of a current fully charged capacity. The ECU 100 estimates the fully charged estimated capacity Ces from, for example, the open circuit voltage OCV at the time when charging is started, the open circuit voltage OCV at the time when charging is ended, and an integrated value of the charging current from the start to the end of charging. For example, the ECU 100 may calculate SOH1 to SOHM of the cells 801 to 80M when the battery 80 is charged by using the EVSE 200.

In S03, the ECU 100 calculates the protection voltage based on the SOH1 to SOHM of the cells 801 to 80M and the temperatures T1 to TN. In S03, the ECU 100 calculates a representative value (for example, an average value, a median value, or a minimum value) of the temperature of the battery 80 from the temperatures T1 to TN acquired in S02. In the present embodiment, the ECU 100 uses the minimum value among the temperatures T1 to TN as the representative value of the temperature of the battery 80. This is based on a consideration of the fact that the lower the temperature becomes, the more likely the Li deposition is to occur.

In addition, the ECU 100 uses a minimum value among the SOH1 to SOHM as a representative value of the SOH of the battery 80. This is based on a consideration of the fact that the lower the SOH becomes, that is, the higher the deterioration degree becomes, the lower the closed circuit potential of the negative electrode CCPN becomes and the more likely the Li deposition is to occur.

The memory 104 of the ECU 100 stores a map or a formula that specifies a relationship between the SOH and the protection voltage of the lithium-ion secondary battery for each temperature of the lithium-ion secondary battery. The ECU 100 refers to the map or the formula to calculate the protection voltage based on the representative value of the temperature and the representative value of the SOH of the battery 80. For example, the ECU 100 calculates the CCV when the closed circuit potential of the negative electrode CCPN reaches the Li deposition potential as the protection voltage.

In S04, the ECU 100 calculates a cell maximum voltage that is a maximum value among the voltages V1 to VM acquired in S02, and compares the calculated cell maximum voltage with the protection voltage obtained in S03.

When the cell maximum voltage is equal to or higher than the protection voltage (at the time when YES determination is made in S04), the ECU 100 proceeds to S05, and calculates a limit current that is an upper limit of the charging current of the battery 80 based on the temperatures T1 to TN of the cells 801 to 80M. The ECU 100 sets the calculated limit current as a target current in charging control of the battery 80. In S05, the ECU 100 calculates a representative value (for example, an average value, a median value, or a minimum value) of the temperature of the battery 80 from the temperatures T1 to TN acquired in S02. In the present embodiment, the ECU 100 uses the minimum value among the temperatures T1 to TN as the representative value of the temperature of the battery 80 in consideration of the fact that the lower the temperature becomes, the more likely the Li deposition is to occur.

The memory 104 of the ECU 100 stores a map or a formula that specifies a relationship between the temperature and the limit current of the lithium-ion secondary battery. The ECU 100 refers to the map or the formula to calculate the limit current from the representative value of the temperature of the battery 80.

In S06, the ECU 100 determines whether a "limiting flag" stored in the memory 104 is set to ON. The limiting flag is set to either ON or OFF. The fact that the limiting flag is ON means that the limit of the charging current of the battery 80 is being performed as the protective measure for the Li deposition. The fact that the limiting flag is OFF means that the limit of the charging current of the battery 80 is not being performed.

When the limiting flag is OFF (at the time when YES determination is made in S06), the ECU 100 calculates a command current I*(n-1) that is a control command value of the charging current in the previous control cycle in S07. In S07, the ECU 100 sets a larger one of the target current calculated in S05 and the current I acquired in S02 as the command current I*(n-1) in the previous control cycle. It should be noted that, when the limiting flag is ON (at the time when NO determination is made in S06), the ECU 100 skips S07.

In S08, the ECU 100 sets the limiting flag to ON. Next, in S09, the ECU 100 calculates the command current I*(n) in the current control cycle.

In S09, the ECU 100 determines a value obtained by reducing the command current I*(n-1) in the previous control cycle in accordance with a maximum limit rate. The "limit rate" is a time change rate (that is, a decrease speed) when the charging current is reduced, and is represented by -dI/dt. The "maximum limit rate" means a maximum value of a magnitude of the limit rate. For example, the maximum limit rate is set in advance by considering electrical characteristics (a follow-up speed with respect to the command current, and the like) of the EVSE 200, the charging circuit 70, and the like.

When a magnitude of the maximum limit rate is defined as dIres/dt, and a length of the control cycle is defined as dt, a value obtained by reducing the command current I*(n-1) in the previous control cycle in accordance with the maximum limit rate is represented by I*(n-1) - dIres. The ECU 100 sets a larger one of the value and the target current (that is, the limit current) obtained in S05 as the command current I*(n) in the current control cycle.

As described above, when the cell maximum voltage is equal to or higher than the protection voltage (at the time when YES determination is made in S04), the ECU 100 reduces the command current I*(n) in each control cycle at the maximum limit rate within a range in which the command current I*(n) does not fall below the limit current.

Returning to S04, when the cell maximum voltage is less than the protection voltage (at the time when NO determination is made in S04), the ECU 100 proceeds to S10, and sets the target current in the charging control of the battery 80 to a maximum current. The "maximum current" is calculated based on an input allowable power Win that is a control upper limit value of the power (charging power) input to the battery 80.

In S11, the ECU 100 sets the limiting flag to OFF. Next, in S12, the ECU 100 calculates the command current I*(n) in the current control cycle. In S12, the ECU 100 determines a value obtained by increasing the command current I*(n-1) in the previous control cycle in accordance with a maximum relaxation rate. A "relaxation rate" is a time change rate (that is, an increase speed) when the charging current is increased, and is represented by +dI/dt. The "maximum relaxation rate" means a maximum value of a magnitude of the relaxation rate. For example, the maximum relaxation rate is set in advance by considering the electrical characteristics of the EVSE 200 and the charging circuit 70.

When the magnitude of the maximum relaxation rate is defined as dIrel/dt and the length of the control cycle is defined as dt, the value obtained by increasing the command current I*(n-1) in the previous control cycle in accordance with the maximum relaxation rate is represented by I*(n-1) + dIrel. The ECU 100 sets a smaller one of the value and the target current (that is, the maximum current) in the current control cycle as the command current I*(n) in the current control cycle.

As described above, when the cell maximum voltage is less than the protection voltage (at the time when NO determination is made in S04), the ECU 100 increases the command current I*(n) in each control cycle at the maximum relaxation rate within a range in which the command current I*(n) does not exceed the maximum current determined from the input allowable power Win.

Returning to S01, when the detection premise condition is not satisfied (at the time when NO determination is made in S01), the ECU 100 proceeds to S13, and sets the target current in the charging control of the battery 80 to the maximum current. As described above, the "maximum current" is calculated based on the input allowable power Win.

In S15, the ECU 100 sets the command current I*(n) in the current control cycle to the target current (that is, the maximum current) obtained in S13.

### Example of Charging Control of Battery

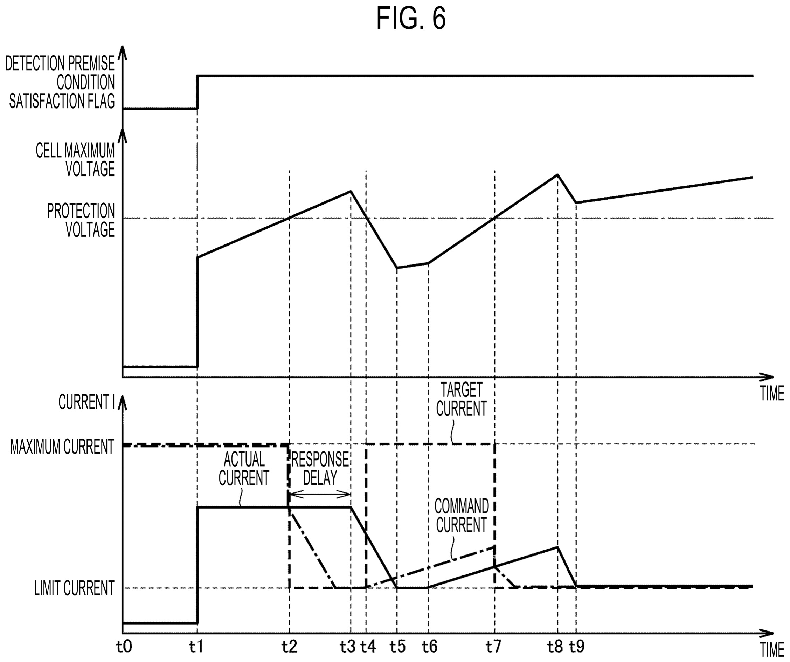

FIG. 6 is a graph for describing an example of the charging control of the battery 80 according to the present embodiment. A horizontal axis of FIG. 6 indicates time, and a vertical axis of FIG. 6 indicates the cell maximum voltage of the battery 80 and the current I flowing through the battery 80. FIG. 6 shows an example of a detection premise condition satisfaction flag, the cell maximum voltage, and time transition of the current I.

The detection premise condition satisfaction flag is set to either ON or OFF. When the detection premise condition satisfaction flag is ON, it means that the detection premise condition described above is satisfied. When the detection premise condition satisfaction flag is OFF, it means that the detection premise condition is not satisfied. In FIG. 6, the detection premise condition satisfaction flag is set to ON at time t1.

In the time transition of the current I shown in FIG. 6, a solid line is a waveform of the current I (that is, an actual current of the battery 80) detected by the current sensor 94. A dotted line is a waveform of the target current calculated based on the temperature of the battery 80. A one-dot chain line is a waveform of the command current I* calculated for each control cycle.

When the detection premise condition satisfaction flag is ON at time t1, the ECU 100 sets the protection voltage for suppressing the Li deposition in accordance with the temperature (the minimum value of the temperatures T1 to TN) and the SOH (the minimum value of the SOH1 to SOHM) of the battery 80. The ECU 100 determines the cell maximum voltage from the voltages V1 to VM acquired from the voltage sensor group 92, and compares the cell maximum voltage with the protection voltage.

Since the cell maximum voltage is less than the protection voltage during a period of times t1 to t2, the target current and the command current are set to the maximum current determined from the input allowable power Win.

When the cell maximum voltage reaches the protection voltage at time t2, the ECU 100 reduces the charging current of the battery 80. Specifically, the ECU 100 calculates the limit current from the temperature (for example, the minimum value of the temperatures T1 to TN) of the battery 80, and sets the calculated limit current as the target current. Further, the ECU 100 sets the command current at time t2 to a larger one of the target current and the actual current of the battery 80, and reduces the command current in each control cycle after time t2 at the maximum limit rate toward the target current (limit current).

Since the ECU 100 starts to reduce the command current at time t2, the actual current of the battery 80 also starts to decrease at a timing delayed from time t2 (time t3) in accordance with the command current. In addition, the cell maximum voltage also decreases as the actual current decreases.

When the cell maximum voltage decreases to the protection voltage at time t4, the ECU 100 changes the target current from the limit current to the maximum current. Then, the ECU 100 increases the command current at the maximum relaxation rate toward a new target current (maximum current). The actual current of the battery 80 is fixed to the limit current after time t5, which is later than time t4. It should be noted that the actual current starts to increase at a timing delayed from time t4 (time t6) in accordance with the increase in the command current.

After time t6, the cell maximum voltage increases as the actual current increases. When the cell maximum voltage reaches the protection voltage again at time t7, the ECU 100 reduces the charging current of the battery 80 again. That is, the ECU 100 changes the target current from the maximum current to the limit current. Further, the ECU 100 sets the command current at time t7 to the larger one of the target current (limit current) and the actual current, and reduces the command current in each control cycle after time t7 at the maximum limit rate toward the target current (limit current). As a result, the actual current of the battery 80 also starts to decrease at time t8 delayed from time t7 and is eventually fixed to the limit current.

As described above, in the present embodiment, (the threshold voltage) for protecting the lithium-ion secondary battery from the Li deposition is variably set in accordance with the deterioration state of the lithium-ion secondary battery. Accordingly, even when a ratio of the resistance of the positive electrode to the resistance of the negative electrode of the lithium-ion battery changes as the deterioration of the lithium-ion secondary battery progresses (refer to FIG. 4), the protection voltage can be appropriately set in consideration of the deterioration state of the lithium-ion secondary battery. Then, by controlling the charging current of the lithium-ion secondary battery based on the set protection voltage, the deposition of the lithium metal can be suppressed even when the lithium-ion secondary battery deteriorates.

It should be considered that the embodiments disclosed here are merely examples in all points and not limited. The scope of the present disclosure is shown by the scope of claims rather than the description of the embodiment described above, and is intended to include all changes within the meaning and scope equivalent to the scope of claims.

## Claims

1. A battery system comprising:
a lithium-ion secondary battery;
a sensor group configured to detect a voltage, a current, and a temperature of the lithium-ion secondary battery; and
a control device configured to control a charging current of the lithium-ion secondary battery based on detection values of the sensor group,
wherein the control device is configured to
acquire a deterioration state of the lithium-ion secondary battery from the detection values of the sensor group,
set a threshold voltage at which lithium metal is deposited on an electrode of the lithium-ion secondary battery with respect to the voltage of the lithium-ion secondary battery, in accordance with the acquired deterioration state of the lithium-ion secondary battery, and
reduce, when the voltage of the lithium-ion secondary battery exceeds the threshold voltage during charging of the lithium-ion secondary battery, the charging current of the lithium-ion secondary battery to a limit current.

2. The battery system according to claim 1, wherein the control device is configured to set the threshold voltage in accordance with the deterioration state and the temperature of the lithium-ion secondary battery.

3. The battery system according to claim 1, wherein the threshold voltage is set to be equal to or less than a closed circuit voltage of the lithium-ion secondary battery when a closed circuit potential of a negative electrode of the lithium-ion secondary battery is a deposition potential of the lithium metal.

4. The battery system according to claim 1, wherein the control device is configured to set, using a map or a formula by which the limit current is specifiable from the temperature of the lithium-ion secondary battery, the limit current based on the temperature of the lithium-ion secondary battery.

5. The battery system according to any one of claims 1 to 4, wherein the lithium-ion secondary battery is a lithium iron phosphate battery.
